Europäisches Patentamt

European Patent Office

Office européen des brevets

(11) Veröffentlichungsnummer: **0 155 708**
**A1**

(12) # EUROPÄISCHE PATENTANMELDUNG

(21) Anmeldenummer: **85200037.1**

(22) Anmeldetag: **16.01.85**

(51) Int. Cl.⁴: **H 03 D 3/10**

(30) Priorität: **20.01.84 AT 189/84**

(43) Veröffentlichungstag der Anmeldung:
**25.09.85 Patentblatt 85/39**

(84) Benannte Vertragsstaaten:
**AT DE FR GB**

(71) Anmelder: **N.V. Philips' Gloeilampenfabrieken
Groenewoudseweg 1
NL-5621 BA Eindhoven(NL)**

(72) Erfinder: **Hasler, Rudolf
P/A INT. OCTROOIBUREAU B.V. Prof. Holstlaan 6
NL-5656 AA Eindhoven(NL)**

(74) Vertreter: **Schoonheijm, Harry Barend et al,
INTERNATIONAAL OCTROOIBUREAU B.V.
Prof.Holstlaan 6
NL-5656 AA Eindhoven(NL)**

(54) Demodulator in Brückenschaltung.

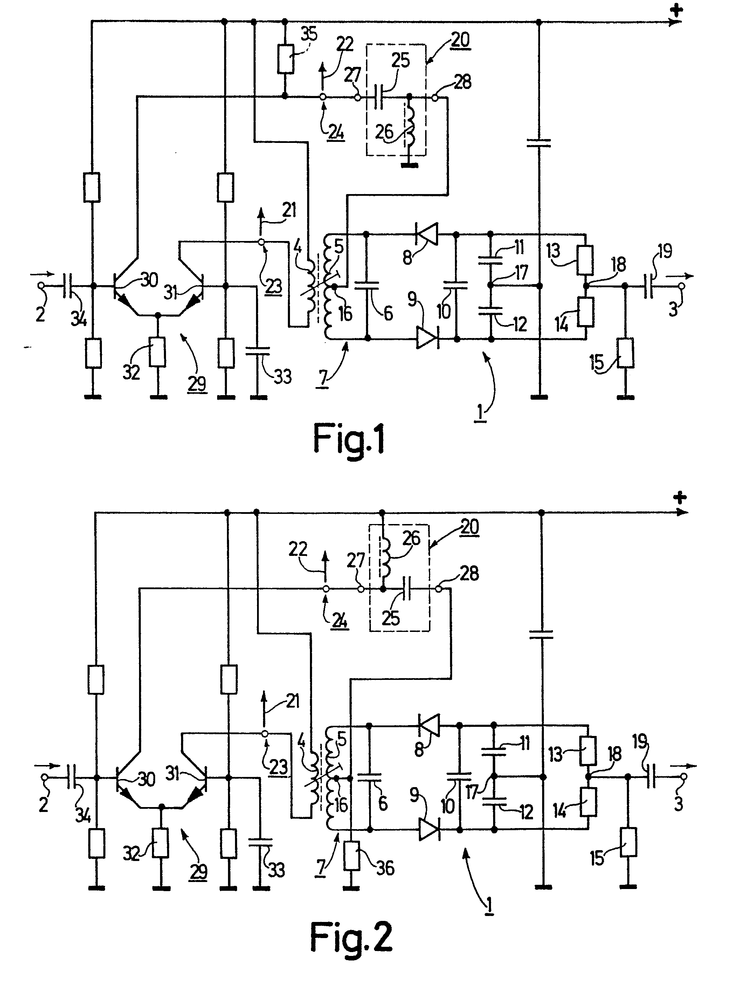

(57) Bei einem Demodulator in Brückenschaltung für frequenzmodulierte Signale, der einen auf die Trägerfrequenz dieser Signale abgestimmten Parallelresonanzkreis (7) aufweist, welcher über eine mit ihm gekoppelte Primärwicklung (4) an eine das zu demodulierende Signal liefernde Signalquelle angeschlossen ist und in dessen eine Brückendiagonale (16, 17) eine gegenüber der Spannung am die andere Brückendiagonale bildenden Parallelresonanzkreis um 90° phasenverschobene Spannung eingekoppelt wird, ist vorgesehen, dass die Primärwicklung an den Parallelresonanzkreis fest angekoppelt ist, dass zur Bildung der gegenüber der Spannung am Parallelresonanzkreis um 90° phasenverschobenen Spannung ein LC-Phasenschiebernetzwerk (20) vorgesehen ist und dass die an der Primärwicklung des Parallelresonanzkreis anliegende Spannung und die am LC-Phasenschiebernetzwerk anliegende Spannung aus hinsichtlich ihrer Phase voneinander unabhängigen Signalquellen (23, 24) gewonnen sind (Figur 1).

Fig.1

EP 0 155 708 A1

Demodulator in Brückenschaltung.


Die Erfindung betrifft einen Demodulator in Brückenschaltung für frequenzmodulierte Signale, der einen auf die Trägerfrequenz dieser Signale abgestimmten Parallelresonanzkreis aufweist, welcher über eine mit ihm gekoppelte Primärwicklung an eine das zu demodulierende Signal liefernde Signalquelle angeschlossen ist und in dessen eine Brückendiagonale eine gegenüber der Spannung am die andere Brückendiagonale bildenden Parallelresonanzkreis um 90$^\circ$ phasenverschobene Spannung eingekoppelt wird. Derartige Demodulatoren sind als Quotientendemodulatoren, auch Ratiodetektoren genannt, oder als Phasendemodulatoren allgemein bekannt. Zur Gewinnung der in die betreffende Brückendiagonale eines solchen Demodulators einzukoppelnden Spannung ist es üblich, eine weitere Wicklung, die auch Tertiärwicklung genannt wird, vorzusehen, die mit der Primärwicklung des Parallelresonanzkreises fest gekoppelt ist, wogegen zwischen der Primärwicklung und dem Parallelresonanzkreis eine lose Kopplung vorgesehen ist, wodurch sich die gewünschte 90$^\circ$ Phasenverschiebung zwischen der Spannung am Parallelresonanzkreis und der in die Brückendiagonale eingekoppelten Spannung ergibt. Eine solche Anordnung von drei Wicklungen ist relativ aufwendig und die erforderlichen unterschiedlichen Kopplungen sind nur durch die mechanische Konstruktion hinsichtlich der Anordnung der Wicklungen festlegbar, wodurch die sich ergebenden Kopplungen relativ toleranzabhängig sind und sich bei einer wie meistens üblichen induktiven Abstimmung des Parallelresonanzkreises die Kopplungen auch je nach der Lage des zur Abstimmung mehr oder weniger in die Wicklungen eintauchenden Kernes aus ferromagnetischem Material ändern können.

Die Erfindung hat sich zum Ziel gesetzt, die vorstehend angeführten Schwierigkeiten zu beseitigen und demgemäss einen besonders einfachen Aufbau für Demodulatoren der eingangs angeführten Gattung anzugeben. Erfindungsgemäss wird dies dadurch erreicht, dass die Primärwicklung an den Parallelresonanzkreis fest angekoppelt ist, dass zur Bildung der gegenüber der Spannung am Parallelresonanzkreis um 90$^\circ$ phasenverschobenen Spannung ein LC-Phasenschiebernetzwerk vorgesehen ist und dass die an der Primärwicklung des Parallelresonanzkreises an-

PHO 84.502 2 0.155708

liegende Spannung und die am LC-Phasenschiebernetzwerk anliegende
Spannung aus hinsichtlich ihrer Phase voneinander unabhängigen Signalquellen gewonnen sind. Auf diese Weise ist keine dritte Wicklung erforderlich, wodurch sich ein einfacher Aufbau ergibt, wobei weiters
die Kopplung zwischen der Primärwicklung und dem Parallelresonanzkreis
dadurch, dass sie nunmehr fest ausgeführt ist, keinen mechanischen
Toleranzen sowie keinen Änderungen bei einer induktiven Abstimmung
des Parallelresonanzkreises unterliegt und schliesslich gestaltet sich
auch die Gewinnung der um 90$^O$ phasenverschobenen Spannung besonders
einfach, da die gewünschte Phasenverschiebung durch diskrete Schaltelemente festlegbar ist.

Im Hinblick auf die Gewinnung der an der Primärwicklung des
Parallelresonanzkreises anliegenden Spannung und der am LC-Phasenschiebernetzwerk anliegenden Spannung aus hinsichtlich ihrer Phase
voneinander unabhängigen Signalquellen gibt es verschiedene Realisierungsmöglichkeiten. So kann beispielsweise die Primärwicklung in den
Ausgangskreis eines Verstärkers aufgenommen sein, in dem weiters
noch ein Arbeitswiderstand vorgesehen ist, von dem her das LC-Phasenschiebernetzwerk angespeist wird. Als besonders einfach hat sich jedoch erwiesen, wenn die hinsichtlich ihrer Phase voneinander unabhängigen
Signalquellen durch die beiden Ausgänge eines Differenzverstärkers gebildet sind. Auf diese Weise ist mit besonderer Sicherheit erreicht,
dass keine Verkopplung zwischen den einerseits an der Primärwicklung
des Parallelresonanzkreises und andererseits am LC-Phasenschiebernetzwerk anliegenden Spannungen erfolgt, wobei sich noch als weiterer
Vorteil ergibt, dass solche Differenzverstärker bereits vielfach in
zur Verarbeitung frequenzmodulierter Signale vorgesehenen integrierten
Schaltkreisen enthalten sind.

Hinsichtlich der Ausbildung des LC-Phasenschiebernetzwerkes
bestehen ebenfalls verschiedene Möglichkeiten. So kann es beispielsweise als Tiefpass geschaltet sein, wobei sich dann bei der Grenzfrequenz des Tiefpasses eine 90$^O$ Phasenverschiebung zwischen seinem
Eingangs- und Ausgangssignal ergibt. Als besonders vorteilhaft hat
sich jedoch erwiesen, wenn das LC-Phasenschiebernetzwerk als Hochpass
mit einem Kondensator am Eingang ausgebildet ist. Auf diese Weise ist
es nämlich möglich, die die Induktivität bildende Spule des Hochpasses
zusätzlich zum Schliessen der Gleichstromwege für die beiden, die
Gleichrichter enthaltenden Brückenzweige des Demodulators zu verwenden.

Die Erfindung wird im folgenden anhand der Zeichnungen, in welchen Schaltbilder einiger Ausführungsbeispiele der Erfindung dargestellt sind, auf welche sie jedoch nicht beschränkt sein soll, naher erläutert.

Figur 1 zeigt einen Ratiodetektor und ein als Hochpass mit einem Kondensator am Eingang ausgeführtes LC-Phasenschiebernetzwerk, wobei dieses und die Primärwicklung des Parallelresonanzkreises des Ratiodetektors je für sich von den beiden Ausgängen eines Differenzverstärkers gespeist werden.

Figur 2 zeigt eine Abwandlung des Ausführungsbeispieles nach Figur 1, wobei das LC-Phasenschiebernetzwerk als Hochpass mit einer Induktivität am Eingang ausgeführt ist.

Figur 3 zeigt eine weitere Abwandlung des Ausführungsbeispieles nach Figure 1, wobei das LC-Phasenschiebernetzwerk und die Primärwicklung des Parallelresonanzkreises des Ratiodetektors dadurch je für sich angespeist werden, dass in den Ausgangskreis eines Verstärkertransistors die Primärwicklung des Parallelresonanzkreises und ein Arbeitswiderstand aufgenommen sind, von dem her das LC-Phasenschiebernetzwerk angespeist wird.

Figur 4 zeigt einen Phasendemodulator und ein als Tiefpass ausgebildetes LC-Phasenschiebernetzwerk, wobei die Art und Weise der Anspeisung der Primärwicklung des Parallelresonanzkreises des Phasendemodulators und des LC-Phasenschiebernetzwerkes wie beim Ausführungsbeispiel nach Figur 3 ausgeführt ist.

Im Schaltbild nach Figur 1 ist mit 1 ein hier als Ratiodetektor ausgebildeter Demodulator in Brückenschaltung bezeichnet, wie er beispielsweise in Rundfunkempfängern zur Demodulation eines mit einem Niederfrequenzsignal als Nutzsignal frequenzmodulierten Trägersignals verwendet wird. Das Trägersignal wird der Schaltungsanordnung über einen Eingang 2 als Zwischenfrequenzsignal zugeführt und an einem Ausgang 3 steht dann das Niederfrequenzsignal zur weiteren Verarbeitung zur Verfügung. Der Ratiodetektor weist in üblicher Weise einen auf die Trägerfrequenz abgestimmten, mit einer Primärwicklung 4 versehenen, durch eine Sekundärwicklung 5 und einen Kondensator 6 gebildeten, Parallelresonanzkreis 7, zwei Gleichrichter 8 und 9, einen Ladekondensator 10, zwei Siebkondensatoren 11 und 12, zwei Arbeitswiderstände 13 und 14 sowie einen Abschlusswiderstand 15 auf. Diese Schaltelemente sind in bekannter Weise wechselstrommässig in einer Brückenschaltung angeordnet, wobei die eine Brückendiagonale durch eine an der Sekundärwicklung 5 vorgesehene Mittelanzapfung 16 und den Verbindungspunkt 17
der beiden Siebkondensatoren 11 und 12 und die andere Brückendiagonale
durch den Parallelresonanzkreis 7 gebildet ist. Das zu demodulierende
Signal wird der durch den Parallelresonanzkreis 7 gebildeten Brückendiagonale von der Primärwicklung 4 her zugeführt, wogegen in die
Brückendiagonale 16, 17 eine gegenüber der Spannung am Parallelresonanzkreis 7 um $90^O$ phasenverschobene Spannung eingekoppelt wird. Das
Nutzsignal tritt am Verbindungspunkt 18 der beiden Arbeitswiderstände
13 und 14 auf, von wo es über einen Trennkondensator 19 zum Ausgang 3
gelangt. Über die Wirkungsweise eines solchen Ratiodetektors erübrigen
sich weitere Bemerkungen, da dies allgemein bekannt ist.

Bei einem solchen Ratiodetektor ist nun vorgesehen, dass die
Primärwicklung 4 an den Parallelresonanzkreis 7 fest angekoppelt ist,
dass zur Bildung der gegenüber der Spannung am Parallelresonanzkreis 7
um $90^O$ phasenverschobenen Spannung ein LC-Phasenschiebernetzwerk 20 vorgesehen ist und dass die an der Primärwicklung 4 des Parallelresonanzkreises 7 anliegende, durch einen Pfeil 21 angedeutete Spannung und die
am LC-Phasenschiebernetzwerk 20 anliegende, durch eine Pfeil 22 angedeutete Spannung aus hinsichtlich ihrer Phase voneinander unabhängigen
Signalquellen 23 und 24 gewonnen sind. Auf diese Weise wird die gegenüber der Spannung am Parallelresonanzkreis 7 um $90^O$ phasenverschobene
Spannung, welche in die Brückendiagonale 16, 17 eingespeist wird, durch
separate diskrete Schaltelemente gewonnen, wodurch die gewünschte
Phasenverschiebung genau festlegbar ist. Weiters kann dadurch, dass die
an der Primärwicklung 4 des Parallelresonanzkreises 7 anliegende
Spannung und die am LC-Phasenschiebernetzwerk 20 anliegende Spannung
aus hinsichtlich ihrer Phase voneinander unabhängigen Signalquellen gewonnen sind, auch keine Verkopplung zwischen der am Parallelresonanzkreis 7 anliegenden Spannung und der in die Brückendiagonale 16, 17
eingespeisten Spannung vorliegen, so dass insgesamt gesehen der
Demodulationsvorgang des frequenzmodulierten Signales exakt vor sich
geht und das Nutzsignal in einwandfreier Weise gewonnen wird. Hierzu
trägt auch noch der Umstand bei, dass die Primärwicklung an den
Parallelresonanzkreis nunmehr fest angekoppelt ist, wodurch durch
Toleranzen bei der Herstellung der Wicklungen 4 und 5 und bei einer
induktiven Abstimmung des Parallelresonanzkreises 7 keine Änderungen
in der vorgesehenen Kopplung zwischen den Wicklungen 4 und 5 hervorgerufen werden.

Beim vorliegenden Ausführungsbeispiel ist das LC-Phasenschiebernetzwerk 20 durch einen Kondensator 25 und eine Spule 26 gebildet, welche hier als Hochpass geschaltet sind, wobei der Kondensator 25 am Eingang 27 des Hochpasses liegt, der Verbindungspunkt des Kondensators 25 mit der Spule 26 den Ausgang 28 des Hochpasses bildet und das andere Ende der Spule an das Bezugspotential angeschlossen ist. Die Kapazität des Kondensators 25 und die Induktivität der Spule 26 sind dabei so gewählt, dass die Grenzfrequenz des Hochpasses der Trägerfrequenz des frequenzmodulierten Signales entspricht, was für dieses Signal zur Folge hat, dass zwischen der am Eingang 27 des Hochpasses anliegenden und der am Ausgang 28 des Hochpasses auftretenden Spannung eine Phasenverschiebung von $90^{\circ}$ besteht. Zur Einspeisung des Ausgangssignals des Hochpasses in die Brückendiagonale 16, 17 ist dessen Ausgang 28 mit der Mittelanzapfung 16 der Sekundärwicklung 5 des Parallelresonanzkreises 7 verbunden und ist der Verbindungpunkt 17 der Siebkondensatoren 11 und 12 ebenso wie die Spule 26 des Hochpasses an das Bezugspotential angeschlossen. Bei einer derartigen Schaltung des Hochpasses dient dessen Spule 26 im Zusammenwirken mit dem Abschlusswiderstand 15 und den Arbeitswiderständen 13 bzw. 14 auch zum Schliessen der Gleichstromwege für die beiden die Gleichrichter 8 bzw. 9 enthaltenden Brückenzweige. Eine andere Möglichkeit für die Einkopplung des Ausgangssignals des Hochpasses in die Brückendiagonale 16, 17 besteht darin, dass die Spule 26 und der Verbindungspunkt 17 der beiden Siebkondensatoren 11 und 12 nicht an das Bezugspotential angeschlossen, sondern miteinander verbunden und ihrerseits an den Verbindungspunkt 18 der beiden Arbeitswiderstände 13 und 14 angeschlossen werden, in welchem Falle dann der Abschlusswiderstand 15 entfallen kann, da sich die Gleichstromwege für die beiden die Gleichrichter 8 bzw. 9 enthaltenden Brückenzweige unmittelbar über die Arbeitswiderstände 13 bzw. 14 schliessen.

Zur Gewinnung der an der Primärwicklung 4 des Parallelresonanzkreises 7 anliegenden Spannung und der am LC-Phasenschiebernetzwerk 20 anliegenden Spannung aus hinsichtlich ihrer Phase voneinander unabhägigen Signalquellen 23 bzw. 24 sind beim vorliegenden Ausführungsbeispiel diese beiden Signalquellen 23 und 24 durch die beiden Ausgänge eines Differenzverstärkers 29 gebildet. In üblicher Weise besteht dieser Differenzverstärker 29 aus zwei Transistoren 30 und 31, deren Emitter an einen gemeinsamen Emitterwiderstand 32 angeschlossen sind und deren Basen je an einem Gleichspannungsteiler liegen, wobei die Basis des Transistors 31 über einen Kondensator 33 wechselstrommässig an das Bezugspotential gelegt ist und die Basis des Transistors 30 über einen Trennkondensator 34 mit dem Eingang 2 der Schaltungsanordnung wechselstrommässig verbunden ist. Ein derartiger Differenzverstärker kann selbstverständlich auch in integrierter Schaltungstechnik ausgeführt sein. Die beiden Kollektoren der Transistoren 30 und 31 bilden die beiden Ausgänge des Differenzverstärkers 29, wobei in den Kollektorkreis des Transistors 30 ein Arbeitswiderstand 35 aufgenommen ist, wogegen in den Kollektorkreis des Transistors 31 unmittelbar die Primärwicklung 4 des Parallelresonanzkreises 7 eingeschaltet ist, was bedeutet, dass die am Arbeitswiderstand 35 abfallende Spannung die Spannung 22 der Signalquelle 24 und die an der Primärwicklung 4 auftretende Spannung die Spannung 21 der Signalquelle 23 bildet. Wie ersichtlich, sind diese Spannung 21 und 22 der beiden Signalquellen 23 und 24 mit besonderer Sicherheit hinsichtlich ihrer Phase voneinander unabhängig, da keine Verkopplung zwischen diesen beiden Signalen besteht. Damit ist auch gewährleistet, dass stets die gewünschte Phasenverschiebung von 90$^{\circ}$ zwischen der am Parallelresonanzkreis 7 auftretenden Spannung und der am Ausgang 28 des LC-Phasenschiebernetzwerkes 20 auftretenden Spannung vorliegt, was für eine einwandfreie Funktionsweise des Ratiodetektors von besonderer Bedeutung ist.

Beim Ausführungsbeispiel nach Figur 2 ist bei sonst im wesentlichen gleichem Aufbau der Schaltungsanordnung wie beim Ausführungsbeispiel nach Figur 1, das LC-Phasenschiebernetzwerk 20 wieder als Hochpass mit einem Kondensator 25 und einer Spule 26 ausgebildet, wobei aber hier am Eingang 27 des Hochpasses die Spule 26 und am Ausgang 28 des Hochpasses der Kondensator 25 liegt. In diesem Falle erübrigt sich im Kollektorkreis des Transistors 30 des Differenzverstärkers 29 der Arbeitswiderstand 35, da nunmehr die Spule 26 unmittelbar in den Kollektorkreis dieses Transistors eingeschaltet werden kann. Da sich aber nunmehr die Gleichstromwege der beiden die Gleichrichter 8 bzw. 9 enthaltenden Brückenzweige des Ratiodetektors nicht mehr über die Spule 26 des Hochpasses schliessen können, ist die Mittelanzapfung 16 der Sekundärwicklung 5 des Parallelresonanzkreises 7 über einen Widerstand 36 an das Bezugspotential gelegt, womit dann wieder die beiden Gleichstromwege über den Widerstand 36, den Abschlusswiderstand 15 und die Arbeitswiderstände 13 bzw. 14 geschlossen sind.

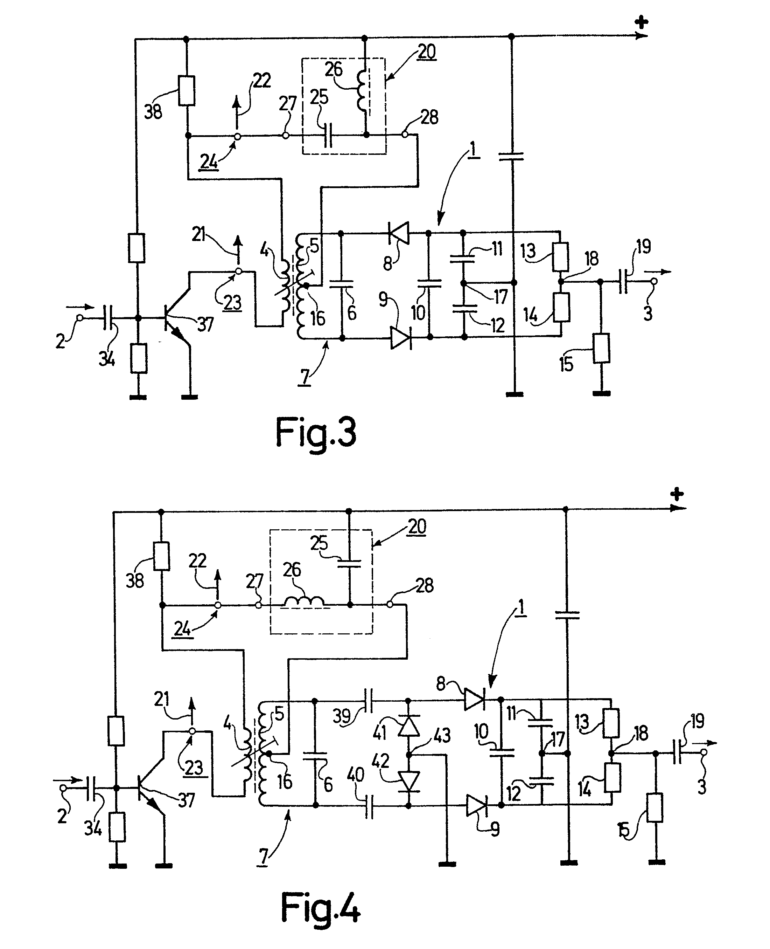

Beim Ausführungsbeispiel nach Figur 3 ist in Abwandlung des Ausführungsbeispieles nach Figur 1 eine andere Realisierung für die hinsichtlich ihrer Phase voneinander unabhängigen Signalquellen 23 und 24 angegeben. Hier ist nur ein Verstärkertransistor 37 vorgesehen, dessen Basis wechselstrommässig mit dem Eingang 2 der Schaltungsanordnung in Verbindung steht. In den Kollektorkreis dieses Transistors 37 ist wieder die Primärwicklung 4 des Parallelresonanzkreises 7 unmittelbar aufgenommen, wodurch wieder die Signalquelle 23 gebildet ist. Hier ist jedoch in den Kollektorkreis des Transistors 37 zusätzlich noch in Serie zur Primärwicklung 4 ein Arbeitswiderstand 38 aufgenommen, womit durch die an ihm abfallende Spannung die Signalquelle 23 gebildet ist, an welche das LC-Phasenschiebernetzwerk 20 angeschlossen ist. Wie ersichtlich, sind auch hier die beiden Signalquellen 23 und 24 hinsichtlich ihrer Phase voneinander unabhängig, da keine Verkopplung zwischen den von ihnen gelieferten Spannungen 21 bzw. 22 vorliegt. Selbstverständlich wäre es auch möglich, zur Bildung der Signalquelle 24 einen in den Emitterkreis des Transistors 37 aufgenommenen Widerstand heranzuziehen. Weiters wäre es beispielsweise bei einer Ausführungsform des LC-Phasenschiebernetzwerk 20 gemäss dem Ausführungsbeispiel nach Figur 2 auch möglich, die Primärwicklung 4 des Parallelresonanzkreis 7 und die Spule 26 des LC-Phasenschiebernetzwerkes 20 in Serienschaltung in den Kollektorkreis des Transistors 37 aufzunehmen oder die Spule 26 in den Emitterkreis des Transistors 37 zu legen.

Das Ausführungsbeispiel nach Figur 4 zeigt als Demodulator 1 einen Phasendemodulator, bei dem bekanntlich die beiden Gleichrichter 8 und 9 in die beiden Brückenzweige mit gleicher Polarität bzw. Durchlassrichtung eingeschaltet sind. Zur Bildung der beiden hinsichtlich ihrer Phase voneinander unabhängigen Signalquellen 23 und 24 ist die gleiche Schaltungsanordnung wie beim Ausführungsbeispiel nach Figur 3 vorgesehen. Als LC-Phasenschiebernetzwerk ist hier jedoch ein durch einen Kondensator 25 und eine Spule 26 gebildeter Tiefpass vorgesehen, dessen Eingang 27 wieder mit der Signalquelle 24 und dessen Ausgang 28 wieder mit der Mittelanzapfung 16 der Sekundärwicklung 5 des Parallelresonanzkreises 7 in Verbindung steht. Die Kapazität des Kondensators 25 und die Induktivität der Spule 26 sind auch hier so gewählt, dass die Grenzfrequenz des Tiefpasses der Trägerfrequenz des frequenzmodulier-

ten Signals entspricht, wodurch wieder für dieses Signal zwischen dem Eingang und dem Ausgang des Tiefpasses eine Phasenverschiebung von 90$^\circ$ besteht. Da im vorliegenden Fall die Mittelanzapfung 16 der Sekundärwicklung 5 des Parallelresonanzkreises 7 über die Spule 26 an einem Gleichspannungspotential liegt, sind zur Abblockung desselben zwischen den Parallelresonanzkreis 7 und die beiden Gleichrichter 8 bzw. 9 Trennkondensatoren 39 bzw. 40 eingeschaltet und werden die Gleichstromwege für die beiden die Gleichrichter 8 bzw. 9 enthaltenden Brückenzweige des Demodulators durch zwei weitere Gleichrichter 41 und 42, deren Verbindungspunkt 43 an das Bezugspotential gelegt ist, geschlossen, dies wieder im Zusammenwirken mit dem Abschlusswiderstand 15 und den Arbeitswiderständen 13 bzw. 14. Selbstverständlich wäre es aber auch möglich, anstelle der beiden Trennkondensatoren 39 und 40 nur einen Trennkondensator vor oder nach dem Tiefpass vorzusehen und die Gleichstromwege für die beiden die Gleichrichter 8 bzw. 9 enthaltenden Brückenzweige des Demodulators über einen von der Mittelanzapfung 16 der Sekundärwicklung 5 des Parallelresonanzkreises 7 zum Bezugspotential führenden Widerstand zu schliessen, analog wie dies beim Ausführungsbeispiel nach Figur 2 geschieht, wobei dann die beiden weiteren Gleichrichter 41 und 42 entfallen könnten.

Wie aus dem Vorstehenden ersichtlich ist, bestehen eine Reihe von Abwandlungen der beschriebenen Ausführungsbeispiele, ohne dass dabei der Rahmen der Erfindung verlassen wird. Dies gilt insbesondere im Hinblick auf die Ausgestaltung der beiden hinsichtlich ihrer Phase voneinander unabhängigen Signalquellen zur Lieferung der an die Primärwicklung des Parallelresonanzkreises und der an das LC-Phasenschiebernetzwerk anzulegenden Spannungen sowie der Art und Weise, wie die gegenüber der Spannung am Parallelresonanzkreis um 90$^\circ$ phasenverschobene Spannung in die betreffende Brückendiagonale eingekoppelt wird und auf welche Art und Weise die Gleichstromwege für die beiden die Gleichrichter enthaltenden Brückenzweigen des Demodulators geschlossen werden.

PATENTANSPRÜCHE:

1.      Demodulator in Brückenschaltung für frequenzmodulierte Signale, der einen auf die Trägerfrequenz dieser Signale abgestimmten Parallelresonanzkreis aufweist, welcher über eine mit ihm gekoppelte Primärwicklung an eine das zu demodulierende Signal liefernde Signalquelle angeschlossen ist und in dessen eine Brückendiagonale eine gegenüber der Spannung am die andere Brückendiagonale bildenden Parallelresonanzkreis um 90$^{\circ}$ phasenverschobene Spannung eingekoppelt wird, dadurch gekennzeichnet, dass die Primärwicklung an den Parallelresonanzkreis fest angekoppelt ist, dass zur Bildung der gegenüber der Spannung am Parallelresonanzkreis um 90$^{\circ}$ phasenverschobenen Spannung ein LC-Phasenschiebernetzwerk vorgesehen ist und dass die an der Primärwicklung des Parallelresonanzkreises anliegende Spannung und die am LC-Phasenschiebernetzwerk anliegende Spannung aus hinsichtlich ihrer Phase voneinander unabhängigen Signalquellen gewonnen sind.

2.      Demodulator nach Anspruch 1, dadurch gekennzeichnet, dass die hinsichtlich ihrer Phase voneinander unabhängigen Signalquellen durch die beiden Ausgänge eines Differenzverstärkers gebildet sind.

3.      Demodulator nach Anspruch 1 oder 2, dadurch gekennzeichnet, dass das LC-Phasenschiebernetzwerk als Hochpass mit einem Kondensator am Eingang ausgebildet ist.

Fig.1

Fig.2

Fig.3

Fig.4

Europäisches
Patentamt

**EUROPÄISCHER RECHERCHENBERICHT**

**0155708**
Nummer der Anmeldung

EP 85 20 0037

## EINSCHLÄGIGE DOKUMENTE

| Kategorie | Kennzeichnung des Dokuments mit Angabe soweit erforderlich, der maßgeblichen Teile | Betrifft Anspruch | KLASSIFIKATION DER ANMELDUNG (Int. Cl 4) |
|---|---|---|---|
| Y | US-A-3 391 345 (A. BURGERT) <br> * Figur 4; Spalte 2, Zeilen 16-30; Spalte 3, Zeilen 37-60 * | 1 | H 03 D 3/10 |
| Y | US-A-2 528 182 (W.F. SANDS et al.) <br> * Figur 1; Spalte 6, Zeilen 38-52 * | 1 | |
| A | US-A-3 158 817 (D.M. LAUDERDALE) <br> * Figur 1; Spalte 1, Zeilen 20-39; Spalte 3, Zeilen 18-37 * | 2 | |
| A | US-A-2 585 532 (V.R. BRIGGS) <br> * Figur 6; Spalte 4, Zeilen 13-49 * | | |
| A | US-A-2 415 468 (R.C. WEBB) <br> * Figur 1; Spalte 3, Zeilen 23-28 * | | |
| A | US-A-3 063 019 (P. DE WAARD et al.) <br> * Figuren 2,5 * | | |

| | | | RECHERCHIERTE SACHGEBIETE (Int. Cl.4) |
|---|---|---|---|
| | | | H 03 D 3/08 <br> H 03 D 3/10 |

Der vorliegende Recherchenbericht wurde für alle Patentansprüche erstellt.

| Recherchenort <br> BERLIN | Abschlußdatum der Recherche <br> 23-04-1985 | Prüfer <br> BREUSING J |
|---|---|---|